# EUROPÄISCHE PATENTANMELDUNG

(11) **EP 4 797 889 A1**
(43) Veröffentlichungstag der Anmeldung: **26.08.2026**
(21) Anmeldenummer: 26155734.2
(22) Anmeldetag: 02.02.2026
(51) Int. Cl.: H05K 7/14, G01D 11/26

(54) **GEHÄUSE FÜR EIN FELDGERÄT DER PROZESSAUTOMATISIERUNGSTECHNIK UND FELDGERÄT**

(30) Priorität: 20.02.2025 DE 102025106456
(71) Anmelder: Endress+Hauser SE+Co. KG, 79689 Maulburg (DE)
(72) Erfinder: Kummle, Rouven, 79664 Wehr (DE); Matt, Pascal, 79541 Lörrach (DE); Meinhardt, Alexander, 79540 Lörrach (DE); Rauch, Stefan, 79664 Wehr (DE)
(74) Vertreter: Endress + Hauser Group Services (Deutschland) AG+Co. KG

(57) **Zusammenfassung**

Die Erfindung bezieht sich auf ein Gehäuse. Ein Deckel (1) weist einen Boden (10) mit einer Aussparung (11) auf, auf dem eine Sichtscheibe (2) unter einer axialen Vorspannung aufliegt. Ein radialer Außenbereich (31) eines ringförmigen Spannrings (3) ist zumindest teilweise in einer Nut (13) angeordnet und ein radialer Innenbereich (33) liegt auf der Sichtscheibe (2) auf. Der Außenbereich (31) und der Innenbereich (33) sind aus miteinander alternierenden V-Formen gebildet, die jeweils zwei aufeinander zugeneigte Schenkel und ein Stirnende (34) aufweisen. In einem Mittenbereich (32) gehen jeweils ein Schenkel einer V-Form des Außenbereichs (31) in einen Schenkel einer V-Form des Innenbereichs (33) über. Der ringförmige Spannring (3) ist in Bezug auf eine in Richtung des Bodens (10) des Deckels (1) wirkende mechanische Kraft elastisch verformbar.

## Beschreibung

Die Erfindung betrifft ein Gehäuse für ein Feldgerät der Prozessautomatisierung. Weiterhin betrifft die Erfindung ein Feldgerät. Das Feldgerät dient z. B. der Bestimmung und/oder Überwachung von Prozessgrößen wie beispielsweise Füllstand, Durchfluss, Massendurchfluss, Druck, Temperatur oder pH-Wert.

In der modernen Technik ist es üblich, Prozesse in Prozessanlagen durch Feldgeräte zu überwachen bzw. zu steuern. Die Feldgeräte sind hierfür entweder als Sensoren oder als Aktoren ausgestaltet. Die Sensoren verfügen in der Regel über ein Gehäuse, in dem sich eine Elektronik befindet, welche mit einer Messeinheit gekoppelt ist. Die Messeinheit erfasst üblicherweise eine Prozessgröße oder eine damit in Verbindung stehende Messgröße. Das Gehäuse ist meist mehrteilig ausgeführt und kann auch ein mehrfaches Öffnen erlauben. Ein Zugang wird dann in der Regel über einen Deckel bewirkt.

Solche Gehäuse oder zumindest die Deckel bestehen z. B. teilweise oder vollständig aus Blech, Kunststoff oder einem Guss-Material, wie z. B. Aludruckguss oder Edelstahlfeinguss. Bekannt sind im Stand der Technik auch Deckel, die einen Blick z. B. auf eine im Gehäuse befindliche Anzeigeeinheit erlauben. Dafür verfügt der sogenannte Sichtdeckel über eine Aussparung, unter der eine Sichtscheibe aus Glas oder einem durchscheinenden Kunststoff angeordnet ist. Für die Fixierung der Sichtscheibe dienen üblicherweise ein Federelement und ein Sicherungsring, wobei sich das Federelement (z. B. eine Wellfeder) auf dem Sicherungsring abstützt. Es sind also mehrere Komponenten erforderlich und die Fertigung ist entsprechend aufwendig.

In der DE 10 2011 088 495 A1 ist ein Deckel mit einer Kontaktscheibe gezeigt, die Zähne aufweist. Die DE 71 49 350 U zeigt ein weiteres Beispiel für einen Deckel. Die DE 102 46 527 A1 offenbart einen Deckel mit einem Klemmstück, das über Nasen verfügt, die abwechselnd nach innen und außen gerichtet sind.

Der Erfindung liegt die Aufgabe zugrunde, ein Gehäuse mit einer Sichtscheibe vorzuschlagen, das sich durch möglichst wenig Bauteile und durch eine möglichst sichere und leichte Montage auszeichnet.

Die Erfindung löst die Aufgabe durch ein Gehäuse für ein Feldgerät der Prozessautomatisierung, mit einem Deckel, mit einer Sichtscheibe, und mit einem im Wesentlichen ringförmigen Spannring, wobei der Deckel einen Boden mit einer Aussparung aufweist, wobei die Sichtscheibe auf dem Boden des Deckels aufliegt, wobei der Deckel in einer Innenwandung eine umlaufende Nut aufweist, wobei der Spannring und die Nut so ausgestaltet und aufeinander abgestimmt sind, dass der Spannring teilweise in der Nut des Deckels angeordnet ist und teilweise aus der Nut herausragt, wobei die Nut, die Sichtscheibe und der Spannring so ausgestaltet und aufeinander abgestimmt sind, dass die Sichtscheibe unter einer axialen Vorspannung steht, wobei der Spannring einen radialen Außenbereich, einen radialen Mittenbereich und einen radialen Innenbereich aufweist, wobei der radiale Außenbereich des Spannrings zumindest teilweise in der Nut angeordnet ist, wobei der radiale Innenbereich des Spannrings auf der Sichtscheibe aufliegt, wobei der radiale Außenbereich und der radiale Innenbereich aus miteinander alternierenden V-Formen gebildet sind, wobei die V-Formen jeweils zwei aufeinander zugeneigte Schenkel und ein Stirnende aufweisen, wobei im radialen Mittenbereich jeweils ein Schenkel einer V-Form des Außenbereichs in einen Schenkel einer V-Form des Innenbereichs übergeht, und wobei der Spannring zumindest abschnittsweise in Bezug auf eine in Richtung des Bodens des Deckels wirkende mechanische Kraft elastisch verformbar ist.

Das erfindungsgemäße Gehäuse verfügt über einen Deckel mit einer Aussparung im Boden, die durch eine Sichtscheibe im Inneren verschlossen wird. Die Sichtscheibe erlaubt es, dass man z. B. eine im Gehäuse befindliche Anzeigeeinheit sehen kann. Damit das Gehäuse durch die Sichtscheibe wieder sicher verschlossen wird, ist der Spannring vorhanden, der die Sichtscheibe gegen den Boden drückt, der also eine axiale Vorspannung erzeugt. Im Stand der Technik ist es bekannt, dass sich ein Spannring als Federelement auf einem Sicherungsring abstützt. Der Aufbau ist dabei der Herstellung des Gehäuses geschuldet, indem zuerst die Sichtscheibe, dann das Federelement und schließlich der - verformungssteife - Sicherungsring eingebracht wird. Der Sicherungsring befindet sich dabei üblicherweise in einer Nut in der Innenwandung des Deckels. Bei der Erfindung kann auf den Sicherungsring verzichtet werden, indem der Spannring zumindest abschnittsweise elastisch verformbar ist. Die Verformbarkeit ist dabei gegeben in Bezug auf eine Kraft, die in Richtung des Bodens des Deckels wirkt.

Für die Montage gibt es beispielsweise zwei Varianten. In einer Variante wird die Sichtscheibe in den Deckel gelegt. Anschließend wird der Spannring eingelegt und axial gegen die Sichtscheibe und damit gegen den Boden des Deckels gepresst. Durch die Verformbarkeit des Spannrings schnappt dessen radialer Außenbereich in die seitliche Nut des Deckels ein. In einer anderen Variante wird die Sichtscheibe in den Spannring eingelegt. Die somit vormontierten Einzelteile werden dann gemeinsam in den Deckel eingebracht und gegen den Boden des Deckels gedrückt. Dies bewirkt wie in der ersten Variante, dass durch die axiale Kraft der Spannring nach radial außen in die Nut des Deckels einschnappt. Das jeweilige Einschnappen des Spannrings ist durch seine Elastizität möglich. Daher ist insbesondere keine separate Auflage durch einen Sicherungsring erforderlich.

Der Spannring besteht aus drei radialen Abschnitten: einem radialen Außenbereich, einem radialen Mittenbereich und einem radialen Innenbereich. Der radiale Außenbereich umfasst dabei radial den Mittenbereich, welcher den Innenbereich radial umfasst. Der radiale Außenbereich befindet sich zumindest teilweise in der Nut und der radiale Innenbereich liegt auf der Sichtscheibe auf und drückt daher die Sichtscheibe gegen den Boden.

Der Außenbereich und der Innenbereich sind jeweils durch V-Formen gebildet. V-förmig sei dabei so verstanden, dass es jeweils zwei Schenkel gibt, die aufeinander zugeneigt sind, und dass es ein Stirnende gibt. Das Stirnende kann dabei so sein, dass sich z. B. die zwei Schenkel in einem eher punktähnlichen Bereich oder in einem sich über eine gewisse Länge erstreckenden Bereich treffen. Dabei umfasst der Mittenbereich des Spannrings die Übergänge zwischen den V-Formen. Mit anderen Worten: Der Mittenbereich realisiert, dass ein Schenkel einer V-Form des Innenbereichs übergeht in die V-Form des Außenbereichs und umgekehrt.

Eine Ausgestaltung besteht darin, dass der radiale Innenbereich, der radiale Außenbereich und/oder der radiale Mittenbereich zumindest teilweise elastisch verformbar sind/ist.

Eine Ausgestaltung des Gehäuses beinhaltet, dass der radiale Außenbereich und/oder der radiale Innenbereich jeweils plan verlaufende Stirnenden aufweisen. In dieser Ausgestaltung enden die V-Formen nicht in einem spitzen Abschnitt, sondern verfügen jeweils über einen Endbereich, der ausreichend Auflagefläche für die Nut und/oder die Sichtscheiben bewirkt.

Eine Ausgestaltung sieht vor, wobei die Stirnenden des radialen Außenbereichs weiter vom Boden als die Stirnenden des radialen Innenbereichs entfernt sind. Mit anderen Worten: Ausgehend vom Boden befinden sich zuerst die Stirnenden des Innenbereichs, dann folgt der Mittenbereich und schließlich sind die Stirnenden des Außenbereichs - mit dem größten Abstand vom Boden - angeordnet. Insofern der Außenbereich den Innenbereich radial umfasst, ergibt sich in dieser Ausgestaltung einer Neigung des Mittenbereichs, sodass sich der Mittenbereich in Richtung des Bodens verengt. In dieser Ausgestaltung hat der Mittenbereich des Spannrings in Richtung des Bodens einen kleineren Durchmesser als in Richtung fort vom Boden. Dies bewirkt im Zusammenhang mit der elastischen Verformbarkeit, dass eine Kraft in Richtung des Bodens eine elastische Aufweitung ermöglicht, dass jedoch eine Bewegung - insbesondere der Sichtscheibe - fort vom Boden blockiert wird.

Eine Ausgestaltung des Gehäuses beinhaltet, dass der Spannring im Wesentlichen aus einem Blech besteht.

Weiterhin bezieht sich die Erfindung auf ein Feldgerät mit einem Gehäuse nach einem der vorangehenden oder folgenden Ausgestaltungen. Die Erläuterungen gelten entsprechend auch für das Feldgerät, sodass auf eine Wiederholung verzichtet wird. Das Feldgerät dient z. B. zum Messen oder Überwachen von Füllstand, Temperatur, Druck, Durchfluss oder pH-Wert.

Die Erfindung wird anhand der nachfolgenden Figuren näher erläutert. Es zeigen:
- Fig. 1:: eine räumliche Darstellung des Gehäuses eines Feldgeräts,
- Fig. 2:: eine Hälfte eines Schnitts durch einen Deckel,
- Fig. 3:: eine räumliche Darstellung des Spannrings des Deckels der Fig. 2.

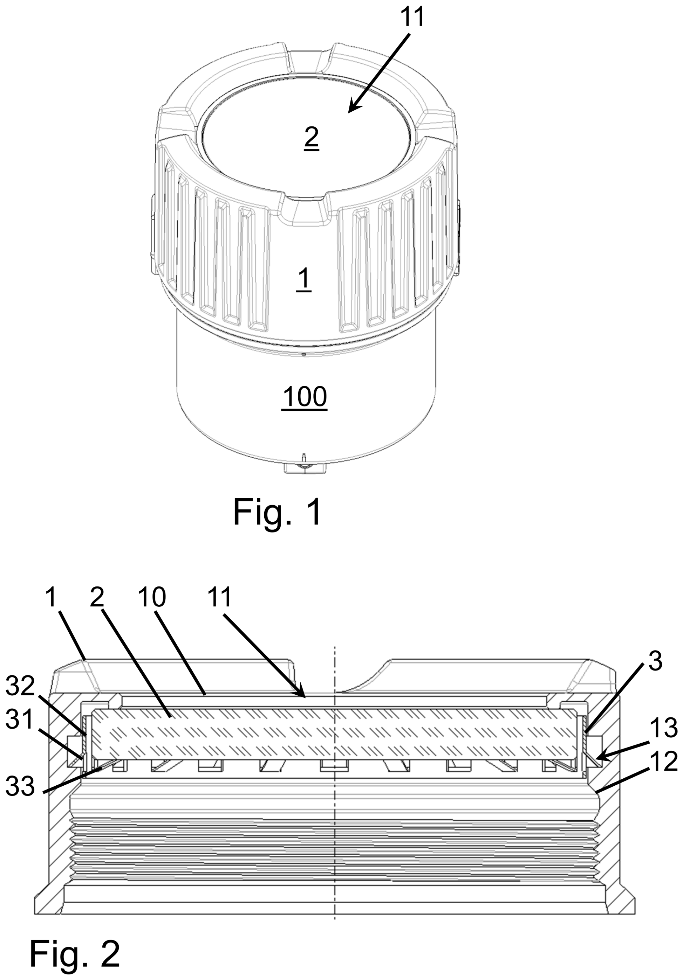

Die Fig. 1 zeigt ein Gehäuse eines Feldgeräts mit einer unteren Komponente, die den Gehäusehals 100 trägt, und einem Deckel 1. Der Deckel 1 verfügt über eine Öffnung 11, durch die z. B. der Blick auf eine unter der Sichtscheibe 2 befindliche - hier nicht dargestellte - Anzeigeneinheit möglich ist. Der Deckel 1 und seine Komponenten sind dabei vorzugsweise rotationssymmetrisch um die Längsachse ausgeführt.

Der Schnitt der Fig. 2 zeigt eine Ausgestaltung des Deckels 1 mit einem Spannring 3.

Der Deckel 1 verfügt über eine kreisrunde Aussparung 11 in seinem Boden 10, auf dem die Sichtscheibe 2 aufliegt. Zu erkennen ist der Hohlraum, der sich hinter der Umrandung der Aussparung 11 und der Sichtscheibe 2 bildet. Hier kann z. B. zusätzlich eine Dichtung eingebracht werden. Die Sichtscheibe 2 wird durch den Spannring 3 gegen den Boden 10 gepresst, indem eine axiale Vorspannung erzeugt wird. Der Spannring 3 liegt dabei in einer umlaufenden Nut 13 der Innenwandung 12 des Deckels 1 auf. Daher ergibt sich die axiale Vorspannung der Sichtscheibe 2 aus der Position der Nut 13 in Verbindung mit der Ausführung des Spannrings 3.

Der Spannring 3 wird - in Richtung des Bodens 10 - vom Außenbereich 31 radial in Richtung des Innenbereichs 33 enger . Der Innenbereich 33 drückt in Richtung des Bodens 10 und damit gegen die Sichtscheibe 2. Der Außenbereich 31 greift in die Nut 13 ein und verhindert eine Bewegung fort vom Boden 10. Die Vorspannung ergibt sich durch das Zusammenwirken der drei Bereiche 31, 32, 33, da sie in Bezug auf ihre jeweilige Orientierung ineinander übergehen: Der Außenbereich 31 und die Innenbereich 33 bestehen jeweils aus einer V-förmigen Struktur, wobei sich die V-Formen von Außenbereich 31 und Innenbereich 33 jeweils miteinander abwechseln. Der Mittenbereich 32 umfasst die Verbindungen der V-Formen durch den Übergang der sich abwechselnden Schenkel.

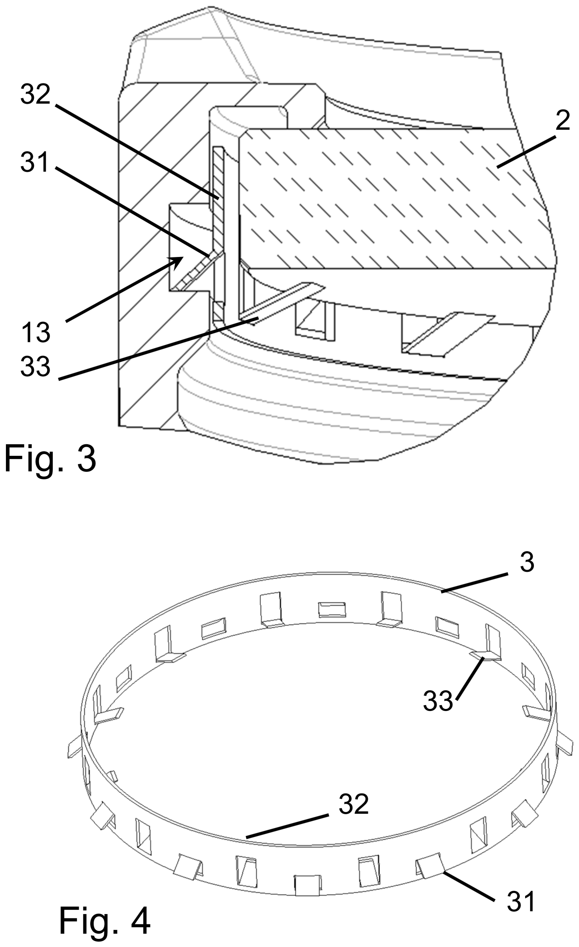

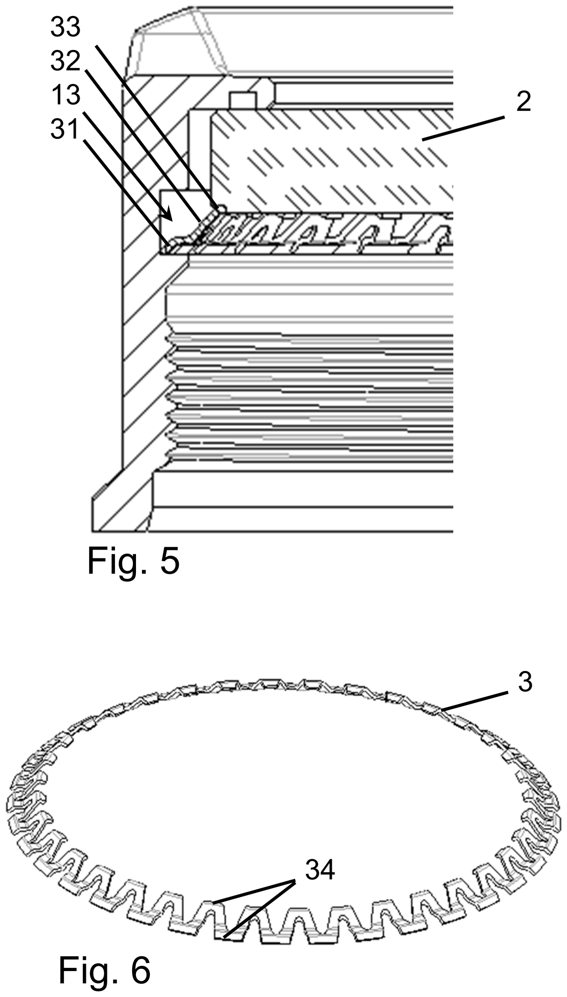

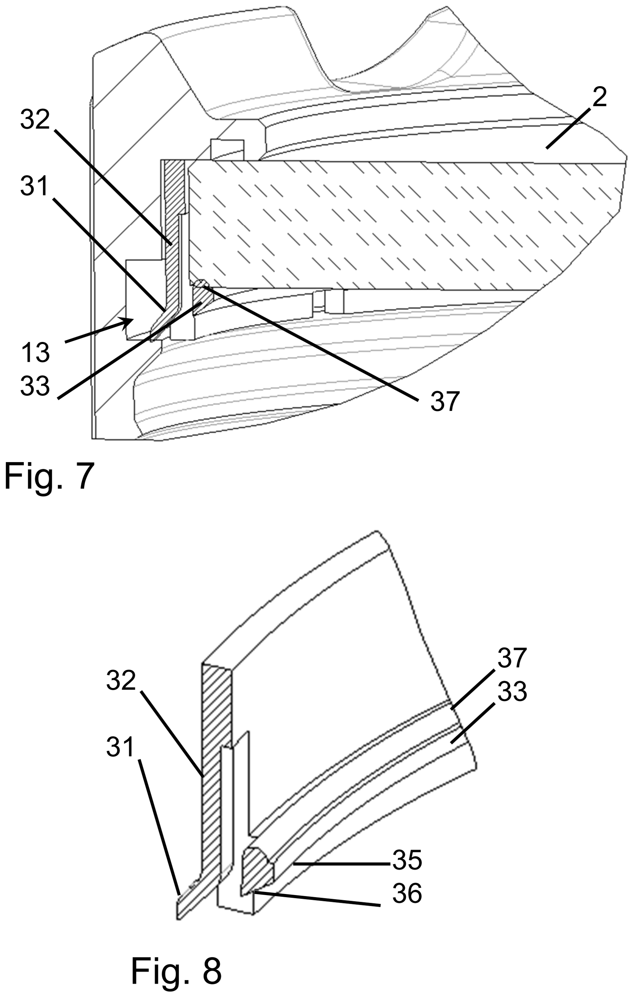

In der Fig. 3 ist zu erkennen, dass es sich bei dem Spannring 3 um einen einteiligen Ring handelt, der über die alternierenden V-Formen verfügt, die entsprechend einmal nach innen und dann nach außen geneigt sind. Die V-Formen umfassen jeweils plan verlaufenden Stirnenden 34, die eine breite Auflagefläche für die Nut 13 bzw. die Sichtscheibe 2 bilden.

Die Montage erfolgt beispielsweise, indem die Sichtscheibe 2 in den Deckel 1 eingebracht und der Spannring 3 eingeführt wird, bis der Spannring 3 auf der Sichtscheibe 2 aufliegt und der Außenbereich 31 in die Nut 13 einschnappt. Alternativ können die Sichtscheibe 2 und der Spannring 3 auch gemeinsam eingebracht werden.

### Bezugszeichenliste

- 1: Deckel
- 2: Sichtscheibe
- 3: Spannring
- 10: Boden
- 11: Aussparung
- 12: Innenwandung
- 13: Nut
- 31: radialer Außenbereich
- 32: radialer Mittenbereich
- 33: radialer Innenbereich
- 34: Stirnende
- 100: Gehäusehals

## Patentansprüche

1. Gehäuse für ein Feldgerät der Prozessautomatisierung,
mit einem Deckel (1),
mit einer Sichtscheibe (2), und
mit einem im Wesentlichen ringförmigen Spannring (3),
wobei der Deckel (1) einen Boden (10) mit einer Aussparung (11) aufweist,
wobei die Sichtscheibe (2) auf dem Boden (10) des Deckels (1) aufliegt,
wobei der Deckel (1) in einer Innenwandung (12) eine umlaufende Nut (13) aufweist,
wobei der Spannring (3) und die Nut (13) so ausgestaltet und aufeinander abgestimmt sind, dass der Spannring (3) teilweise in der Nut (13) des Deckels (1) angeordnet ist und teilweise aus der Nut (13) herausragt,
wobei die Nut (13), die Sichtscheibe (2) und der Spannring (3) so ausgestaltet und aufeinander abgestimmt sind, dass die Sichtscheibe (2) unter einer axialen Vorspannung steht,
wobei der Spannring (3) einen radialen Außenbereich (31), einen radialen Mittenbereich (32) und einen radialen Innenbereich (33) aufweist,
wobei der radiale Außenbereich (31) des Spannrings (3) zumindest teilweise in der Nut (13) angeordnet ist,
wobei der radiale Innenbereich (33) des Spannrings (3) auf der Sichtscheibe (2) aufliegt, wobei der radiale Außenbereich (31) und der radiale Innenbereich (33) aus miteinander alternierenden V-Formen gebildet sind,
wobei die V-Formen jeweils zwei aufeinander zugeneigte Schenkel und ein Stirnende (34) aufweisen,
wobei im radialen Mittenbereich (32) jeweils ein Schenkel einer V-Form des Außenbereichs (31) in einen Schenkel einer V-Form des Innenbereichs (33) übergeht, und
wobei der Spannring (3) zumindest abschnittsweise in Bezug auf eine in Richtung des Bodens (10) des Deckels (1) wirkende mechanische Kraft elastisch verformbar ist.

2. Gehäuse nach Anspruch 1,
wobei der radiale Außenbereich (31) und/oder der radiale Innenbereich (33) jeweils plan verlaufende Stirnenden (34) aufweisen.

3. Gehäuse nach Anspruch 1 oder 2,
wobei die Stirnenden (34) des radialen Außenbereichs (31) weiter vom Boden (10) als die Stirnenden (34) des radialen Innenbereichs (33) entfernt sind.

4. Feldgerät zum Bestimmen und/oder Überwachen mindestens einer Prozessgröße mit einem Gehäuse nach einem der Ansprüche 1 bis 3.
